## Europäisches Patentamt
## European Patent Office
## Office européen des brevets

(19)

(11) Veröffentlichungsnummer: **0 075 708**
**A2**

(12) **EUROPÄISCHE PATENTANMELDUNG**

(21) Anmeldenummer: **82107489.5**

(22) Anmeldetag: **17.08.82**

(51) Int. Cl.³: **H 01 J 29/00**

(30) Priorität: **30.09.81 DE 3138900**

(43) Veröffentlichungstag der Anmeldung:
**06.04.83 Patentblatt 83/14**

(84) Benannte Vertragsstaaten:
**DE FR GB NL**

(71) Anmelder: **SIEMENS AKTIENGESELLSCHAFT**
**Berlin und München Wittelsbacherplatz 2**
**D-8000 München 2(DE)**

(72) Erfinder: **Lischke, Burkhard, Prof. Dr.**
**In der Heuluss 13**
**D-8000 München 83(DE)**

(72) Erfinder: **Frosien, Jürgen, Dr.**
**An der Ottosäule 18**
**D-8012 Ottobrunn(DE)**

(54) Direktgeheizte Kathode mit Heizungsregelung in Elektronenstrahlgeräten und Verfahren zu ihrem Betrieb.

(57) Ein direktgeheizte Kathode mit Heizungsregelung in Elektronenstrahlgeräten soll über lange Zeiträume hinweg eine stabilisierte Temperatur(T) aufweisen. Erfindungsgemäß weist eine direktgeheizte Kathode Mittel (RS) zur Leistungsregelung der Kathodenheizung mit Hilfe von Mitteln (MV) zur Steuerung des Heizstromes (I) und der Heizspannung (U) auf. Erfindungsgemäß wird eine direktgeheizte Kathode so betrieben, daß ihre Kathodentemperatur konstant ist.

FIG 1

EP 0 075 708 A2

Direktgeheizte Kathode mit Heizungsregelung in Elektronenstrahlgeräten und Verfahren zu ihrem Betrieb

Die Erfindung betrifft eine direktgeheizte Kathode mit
Heizungsregelung in Elektronenstrahlgeräten nach dem
Oberbegriff des Anspruchs 1.

Bei direktgeheizten Kathoden in Elektronenstrahlgeräten,
z.B. in Elektronenstrahl-Meßgeräten oder in Elektronenstrahl-Bearbeitungsgeräten, ist es bekannt, die Kathodenheizung mit geregelten Konstantstromquellen bzw. Konstantspannungsquellen zu betreiben.

Konstantstromquellen haben den Nachteil, daß die Kathoden
mit zunehmendem Alter überheizt werden, da durch Materialverlust der Drahtdurchmesser geringer wird. Die mit der
Materialabdampfung einhergehende Widerstandserhöhung $\Delta R$
der Kathode bewirkt einen zunehmenden Leistungsumsatz $\Delta P$
in der Kathode und damit einen stetigen Temperaturanstieg
$\Delta T$ der Kathode. Hierdurch wird die Lebensdauer der
Kathode stark verkürzt. Bei geregelten Konstantstromquellen gilt:

$$\Delta P = I^2 \cdot \Delta R, \text{ mit } I = \text{Heizstrom} = const.$$

Bei Kathodenheizungen mit Konstantspannungsquellen hingegen nimmt die Kathodentemperatur mit zunehmendem
Kathodenalter ab. Durch die Widerstandserhöhung $\Delta R$ des
Kathodendrahtes wird der Leistungsumsatz um $\Delta P$ verringert,
wodurch die Kathodentemperatur um $\Delta T$ sinkt. Bei geregelten Konstantspannungsquellen gilt:

My 1 Kow / 28.9.1981

81 P 7 167 E

$$\triangle P = - \frac{U^2}{R^2} \cdot \triangle R, \quad U = \text{Heizspannung} = \text{const.}$$

Um ein ständiges Nachstellen der Heizspannung bei geregelten Konstantspannungsquellen zu vermeiden, wird in der Praxis die Kathode von vornherein überheizt betrieben, was wiederum eine verkürzte Lebensdauer, ähnlich wie bei der geregelten Konstantstromquelle zur Folge hat.

Der vorliegenden Erfindung liegt die Aufgabe zugrunde, eine direktgeheizte Kathode mit Heizungsregelung in Elektronenstrahlgeräten der eingangs genannten Art anzugeben, welche über lange Zeiträume hinweg eine stabilisierte Temperatur T aufweist.

Diese Aufgabe wird erfindungsgemäß durch eine direktgeheizte Kathode der eingangs genannten Art gelöst, welche die kennzeichnenden Merkmale des Anspruchs 1 aufweist.

Durch die Erfindung wird eine Steigerung der Lebensdauer direktgeheizter Kathoden oder bei gleicher Lebensdauer wie beim Stand der Technik eine Steigerung des Richtstrahlwertes in Elektronenstrahl-Meßgeräten oder Elektronen-Mikroskopen bzw. in sonstigen Elektronenstrahl-Bearbeitungsgeräten erreicht.

Ausgestaltungen und Vorteile der Erfindung sind in den Unteransprüchen, der Beschreibung und der Zeichnung dargestellt.

Bei einer erfindungsgemäßen direktgeheizten Kathode wird nicht der Heizstrom bzw. die Heizspannung, sondern die Heizleistung konstant gehalten. Hierzu werden über eine Regelschaltung sowohl der Heizstrom als auch die Heizspannung der Kathode gemessen. Die Regelschaltung steuert eine der beiden oder auch beide Größen, nämlich Heizstrom und/oder Heizspannung der Kathode, derart, daß das Produkt aus beiden Größen, nämlich die Leistung, konstant bleibt.

Die Erfindung ist in der Zeichnung dargestellt und wird im folgenden näher erläutert.

Figur 1 zeigt eine stromgeregelte Kathodenheizung nach dem Stand der Technik.

Figur 2 zeigt eine spannungsgeregelte Kathodenheizung nach dem Stand der Technik.

Figur 3 zeigt ein Prinzipschaltbild einer erfindungsgemäßen leistungsgeregelten Kathodenheizung.

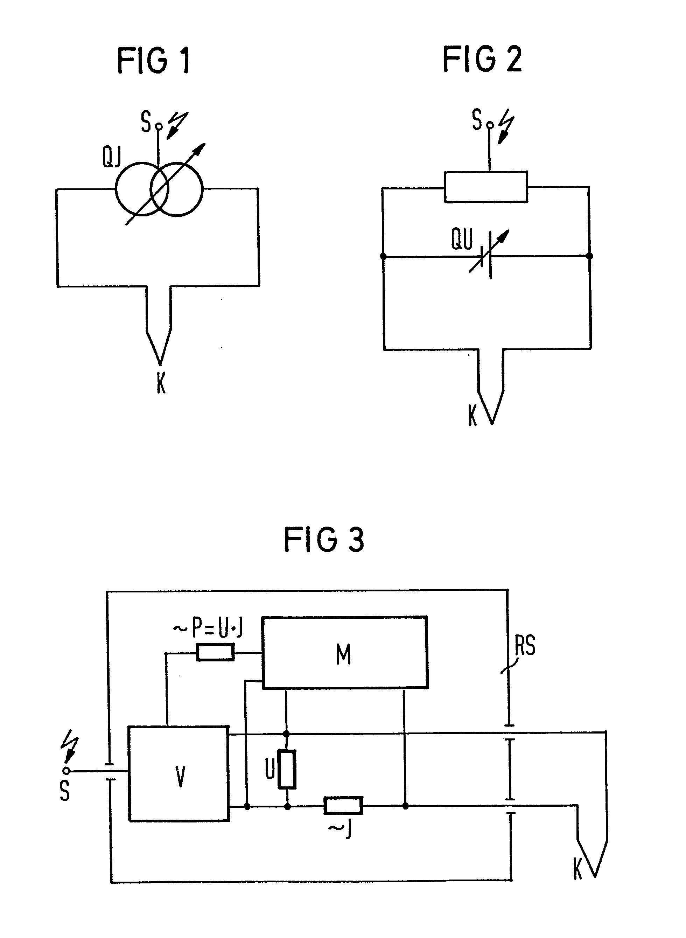

Figur 1 zeigt eine Kathodenheizung mit einer geregelten Konstantstromquelle QI nach dem Stand der Technik. Die Konstantstromquelle QI ist eine Schaltungsanordnung für Gleich-            —ströme zur Bereitstellung eines vom Lastwiderstand unabhängigen Stromes. Eine Konstantstromquelle QI kann als aktiver Zweipol mit einem wesentlich größeren Innenwiderstand als dem maximal möglichen Lastwiderstand durch Stromgegenkopplung oder als aktiver Zweipol mit geregeltem Klemmenstrom realisiert werden. S ist die Eingangsspannung der Konstantstromquelle QI. Der Strom I bewirkt eine stromgeregelte Kathodenheizung der Kathode K.

Figur 2 zeigt eine spannungsgeregelte Kathodenheizung nach dem Stand der Technik. Eine Konstantspannungsquelle QU ist eine Schaltungsanordnung für Gleichspannungen zur Bereitstellung einer vom Lastwiderstand unabhängigen Klemmspannung U. Eine Konstantspannungsquelle kann realisiert werden als aktiver Zweipol mit einem Innenwiderstand gleich Null durch Spannungsgegenkopplung oder mittels Emitterfolgers sowie als aktiver Zweipol mit geregelter Klemmenspannung U. Die geregelte Gleichspannungsquelle QU nach Figur 2 hat die Eingangsspannung
S und die geregelte Ausgangsspannung U. Die geregelte
Ausgangsspannung U bewirkt eine spannungsgeregelte
Kathodenheizung der Kathode K. Die am meisten verwendete
direktgeheizte Kathode bei Elektronenstrahlgeräten ist
eine Wolfram-Haarnadel-Kathode K.

Figur 3 zeigt ein Prinzipschaltbild einer erfindungsgemäßen leistungsgeregelten Kathodenheizung. Zur Erreichung
einer konstanten, vom Alter der Kathode K unabhängigen
Temperatur werden erfindungsgemäß Mittel zur leistungsgeregelten Kathodenheizung verwendet. Bei einem erfindungsgemäßen Kathodenheizungstyp wird primär nicht der Heizstrom bzw. die Heizspannung, sondern die Heizleistung
konstant gehalten. Hierzu mißt die Regelschaltung RS sowohl den Heizstrom I als auch die Heizspannung U und
steuert eine der beiden oder auch beide Größen derart,
daß das Produkt aus Heizspannung U und Heizstrom I,
nämlich die Leistung P, konstant bleibt. Bei einer leistungsgeregelten Kathodenheizung gilt:

$$P = U \cdot I = I^2 \cdot R_{Kathode} = const.$$

Da die bei der Kathodenheizung umgesetzte Leistung P
direkt proportional zur Temperatur der Kathode K ist,
bleibt die Kathodentemperatur unabhängig vom sich ändernden
Kathodenwiderstand $R_{Kathode}$ konstant. Durch diese Leistungsregelung kann stets die für die Elektronenemission optimale
Kathodentemperatur eingestellt und zeitlich konstant gehalten werden. Da hierbei eine unbeabsichtigte Überheizung
der Kathode K vermieden wird, ist mit einer höheren Lebensdauer der Kathode K als nach dem Stand der Technik möglich, zu rechnen. Es kann aber auch von vornherein eine
höhere Kathodentemperatur und damit ein höherer Richtstrahlwert des Elektronenstrahlgerätes eingestellt werden, der dann durch die erfindungsgemäße Regelschaltung RS konstant gehalten wird. Die vorgeschlagene leistungsgeregelte Kathodenheizung arbeitet dann effektiv, wenn die Zuleitungswiderstände zwischen Regelschaltung RS und Kathode K klein gegen den Kathodenwiderstand $R_{Kathode}$ sind. Sind die Zuleitungswiderstände zwischen Regelschaltung RS und Kathode K und der Kathodenwiderstand $R_{Kathode}$ von vergleichbarer Größe, dann muß in der Regelschaltung RS der Leistungsumsatz an den Zuleitungswiderständen zwischen Regelschaltung RS und Kathode K bei der Festlegung des Leistungs-Sollwertes zur Erzielung einer bestimmten Kathodentemperatur berücksichtigt werden.

Die Regelschaltung RS enthält einen Multiplikator M, welcher die gemessene Heizspannung U und eine Größe, welche dem Heizstrom I proportional ist, zu einer Größe multipliziert, welche der Heizleistung $P = U * I$ proportional ist. Über diese Ausgangsgröße des Multiplikators M, welche der Heizleistung P proportional ist, werden in der Versorgung V der Heizstrom I und die Heizspannung U gesteuert. Die Versorgung V hat die Eingangsspannung S.

6 Patentansprüche
3 Figuren

Patentansprüche:

1. Direktgeheizte Kathode mit Heizungsregelung in Elektronenstrahlgeräten, g e k e n n z e i c h n e t durch Mittel (RS) zur Leistungsregelung der Kathodenheizung mit Hilfe von Mitteln (M, V) zur Steuerung des Heizstromes (I) und der Heizspannung (U).

2. Direktgeheizte Kathode nach Anspruch 1, dadurch g e k e n n z e i c h n e t , daß die Zuleitungswiderstände zwischen Regelschaltung (RS) und Kathode (K) klein sind gegen den Kathodenwiderstand.

3. Verfahren zum Betrieb einer direktgeheizten Kathode nach Anspruch 1 oder 2, dadurch g e k e n n z e i c h n e t , daß eine konstante Kathodentemperatur eingestellt wird.

4. Verfahren zum Betrieb einer direktgeheizten Kathode nach Anspruch 1 bis 3, dadurch g e k e n n z e i c h n e t , daß die für die Elektronenemission optimale Kathodentemperatur eingestellt wird.

5. Verfahren zum Betrieb einer direktgeheizten Kathode nach Anspruch 1 bis 4, dadurch g e k e n n z e i c h n e t , daß ein höherer Richtstrahlwert des Elektronenstrahlgerätes über eine Erhöhung der Kathodentemperatur eingestellt wird.

6. Verfahren zum Betrieb einer direktgeheizten Kathode nach Anspruch 1 bis 5, dadurch g e k e n n z e i c h n e t , daß in der Regelschaltung (RS) der Leistungsumsatz in den Zuleitungswiderständen zwischen der Regelschaltung (RS) und der Kathode (K) berücksichtigt wird.

1/1

FIG 1

FIG 2

FIG 3